# EUROPEAN PATENT APPLICATION

(11) **EP 4 174 208 A1**
(43) Date of publication of application: **03.05.2023**
(21) Application number: 22197805.9
(22) Date of filing: 26.09.2022
(51) Int. Cl.: C23C 14/35, H01J 37/34, C23C 14/34

(54) **PVD METHOD AND APPARATUS**

(30) Priority: 29.10.2021 GB 202115616
(71) Applicant: SPTS Technologies Limited, Newport Gwent NP18 2TA (GB)
(72) Inventor: Wilby, Tony, Newport (GB); Burgess, Stephen, Newport (GB); Thomas, Adrian, Newport (GB); Haymore, Scott, Newport (GB)
(74) Representative: Wynne-Jones IP Limited

(57) **Abstract**

According to the present invention there is provided a method of depositing a deposition material into a plurality of recesses formed in a substrate by Physical Vapour Deposition (PVD) comprising the steps of:
positioning the substrate on a substrate supporting upper surface of a substrate support, wherein an arrangement of permanent magnets is positioned beneath the substrate supporting upper surface so that permanent magnets are disposed underneath the substrate; and
depositing the deposition material into the recesses formed in the substrate by sputtering a sputtering material from a target of a magnetron device;
in which, during the step of depositing the deposition material, the arrangement of permanent magnets provides a substantially uniform lateral magnetic field across the surface of the substrate which extends into a region beyond a periphery of the substrate to enhance resputtering of deposited material deposited into the recesses.

## Description

This invention relates to methods of depositing a deposition material on to a substrate by Physical Vapour Deposition (PVD) with particular reference to methods of depositing a deposition material into a plurality of recesses formed in a substrate by PVD. The invention relates also to associated PVD apparatus.

Thin metal or metal nitride layers deposited by PVD are commonly used in the manufacturing process for fabricating back end of line (BEOL) interconnect layers in semiconductor devices. Examples of materials deposited in these processes include Ti, TiN, Ta, TaN, W, WN, Co, Ru and Cu. When using copper damascene metallization, it is necessary to deposit a thin adhesion and/or barrier layer of, for example, Ti prior to PVD deposition of the copper seed layer and subsequent electrochemical (ECD) copper deposition. Two layers may be deposited instead of a single adhesion/ barrier layer. For example, layers of Ti and TiN can be deposited. In applications such as high aspect ratio through silicon vias (TSVs), the formation of continuous metal barrier and seed layers is needed to enable successful ECD of bulk copper into the via. A via with an aspect ratio of 5:1 or greater with an opening diameter of ~0.5-10µm diameter can be considered to be a high aspect ratio via, although this is not an exhaustive definition.

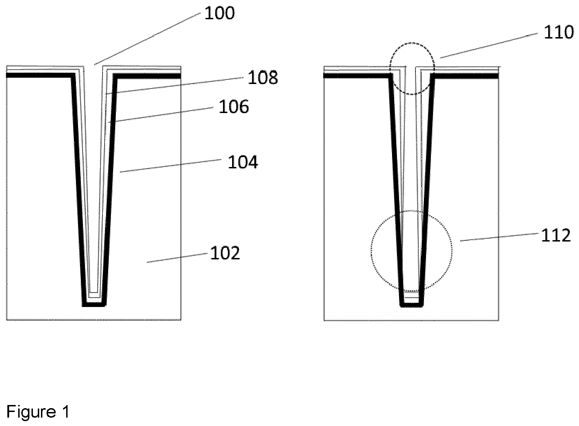

Figure 1(a) shows a semi-schematic representation of a TSV following an idealized PVD deposition process in which there is no restriction at the opening to the via. Figure 1(b), on the other hand, displays some of the problems that should be avoided for the successful processing of wafers. In Figure 1(a), a TSV 100 is etched into a silicon wafer 102. A dielectric liner 104 of a suitable material such as SiO₂ is then deposited within the opening typically by a CVD or ALD process. This is then followed by the deposition of a barrier layer 106 of, for example, Ti by ionized PVD, which is followed by the deposition of a copper layer 108 by ionized PVD. All of the layers need to be continuous. This is especially challenging for PVD processes, particularly for higher aspect ratio features as it is difficult to coat the sidewalls of a via with a relatively normal incidence of material entering the via from the target. In Figure 1(b) two of the problems that need to be avoided can be observed. At the top of the opening under normal PVD deposition conditions, we would expect the deposition rate in the field (the surface of the wafer) to be much greater than within the via. This results in an overhang 110 at the top of the via which will in turn reduce the amount of deposition material that can enter the feature. Deposition of material on to the lower regions 112 of the via is especially reduced. Ultimately this could result in closure of the feature which is unacceptable. However, even a slight narrowing of the opening would make the following ECD copper deposition process more demanding, while a void in the via would result in a defective device.

Conventional means of achieving continuous barrier and seed layer films use ionized PVD (i-PVD) systems with a resputtering capability. Ionized PVD systems use a high density plasma source in the vicinity of the target either through the use of an immersed ICP coil, magnetic confinement or very high power pulses to the target, or a combination of these techniques. This provides a source of metal ions which can be directed towards the wafer support. A high fractional ionization of the metal is required, and typically a fractional ionization of at least 30% is achieved. Frequently, magnetic confinement is used to minimized losses as metal ions and electrons travel towards the wafer support. To maximize base coverage of features, these prior art systems tend to operate with relatively large target to wafer separation of greater than 10cm. This is to minimize the amount of material arriving at non-normal incidence to the wafer surface. Non-normal flux of sputtered material is likely to close the via opening as shown in Figure 1(b). Examples of these types of ionized PVD systems are described in US2012/0228125 A1, US7504006 B2, US2018/0327893 A1, US8435389 B2 and US7378001 B2.

By operating at a low pressure of a few mTorr to minimize scattering and a large target to wafer separation to collimate the flux of material reaching the wafer surface, an ionized source can provide a high flux of metal ions directed to the wafer. If this flux is coupled with a negative DC bias on the wafer support, to attract cations to the wafer, it is possible to achieve excellent base coverage. A negative DC bias is achieved by applying an RF bias power to the support. However, it is not possible to direct the ionized material onto the sidewalls of the feature in order to achieve good step coverage. Adequate sidewall coverage is achieved by resputtering the material within the feature. Immersed ICP coils in the vicinity of the wafer and electromagnets near the wafer have been used to maintain a high density plasma close to the wafer to aid the resputtering process.

All of these prior art i-PVD systems have shortcomings. They are very complex and costly, with a requirement to supply high DC power to the target. DC powers of greater than 10kW are typically necessary, resulting in a target power density of greater than 20W/cm² for a 300mm diameter wafer system in order to achieve a sufficiently dense plasma. Potentially, more than one RF supply may be required if an immersed ICP coil system is used. Electromagnets are frequently required to contain and direct the plasma. A further problem is a relatively low target utilization due to the large separation between the target and the wafer.

Therefore there is a need for a more simple, more cost effective PVD system capable of achieving equivalent or ideally improved process performance with more efficient target utilization. There is also a general desire for improved process performance with PVD into recess features such as vias. In particular, there is a desire for PVD processes and apparatus which can deliver high quality continuous films within a recess feature with excellent sidewall coverage. A related desire is to achieve improved step coverage. There is also a desire to avoid the problem associated with overhang shown in Figure 1(b).

The present invention, in at least some of its embodiments, addresses the above described problems, needs and desires.

According to a first aspect of the invention there is provided a method of depositing a deposition material into a plurality of recesses formed in a substrate by Physical Vapour Deposition (PVD) comprising the steps of:
positioning the substrate on a substrate supporting upper surface of a substrate support, wherein an arrangement of permanent magnets is positioned beneath the substrate supporting upper surface so that permanent magnets are disposed underneath the substrate; and
depositing the deposition material into the recesses formed in the substrate by sputtering a sputtering material from a target of a magnetron device;
in which, during the step of depositing the deposition material, the arrangement of permanent magnets provides a substantially uniform lateral magnetic field across the surface of the substrate which extends into a region beyond a periphery of the substrate to enhance resputtering of deposited material deposited into the recesses.

The arrangement of permanent magnets can be positioned beneath the substrate supporting upper surface so that permanent magnets are additionally disposed beyond the periphery of the substrate. These arrangements are advantageous because they assist in producing the substantially uniform lateral magnetic field across the surface of the substrate which extends into a region beyond a periphery of the substrate. However, a substantially uniform lateral magnetic field of this type can be produced using an arrangement of permanent magnets which is underneath the substrate but does not extend beyond the periphery of the substate. Typically, the arrangement of permanent magnets extends close to the periphery of the substate in these instances, for example to 1-2 cm of the periphery of the substrate.

The target and the substrate can be separated by a gap of 2.5 to 7.5 cm. The target and the substrate can be separated by a gap of 2.5 to 4 cm. It is advantageous that relatively short target to substrate spacings can be achieved for the reasons described above.

A DC power can be applied to the target to sputter the material. This DC power can be applied to the target to sputter the material with an applied power density of 0.1 to 5 Wcm⁻². The applied power density can be 0.25 to 1 Wcm⁻². It is a substantial advantage that it is possible to implement the invention in an effective way without requiring the use of i-PVD methodologies, such as high target power, to achieve high fractional ionization. Also, it is not necessary to use features associated with i-PVD, such as an immersed ICP coil and magnetic confinement above the substrate using electromagnets, to implement the invention.

The arrangement of permanent magnets can be moveable. During the step of depositing the deposition material, the arrangement of permanent magnets can be subjected to a motion which allows the substantially uniform lateral magnetic field to be provided. The motion that the moveable arrangement of permanent magnets is subjected to can be rotation. The moveable arrangement of permanent magnets can be rotated at 2.5 to 15 rpm. The moveable arrangement of permanent magnets can be rotated at 5 to 10 rpm.

Alternatively, the motion that the moveable arrangement of permanent magnets is subjected to can be a reciprocating motion. Other motions that achieve an acceptably uniform lateral magnetic field might be contemplated. However, rotational and reciprocating motions are particularly advantageous, since they can be implemented in an effective and economical way. In principle, the magnets in the arrangement of permanent magnets can be static and still produce a sufficiently uniform lateral magnetic field.

The substantially uniform lateral magnetic field which is provided across the surface of the substrate and extends into a region beyond the periphery of the substrate can have a magnetic field strength in the range 100-500 Gauss (0.01-0.05 Tesla).

Ar or He can be used as a process gas during the step of depositing the deposition material. Ar and He have been found to give rise to particularly advantageous results. Ar can provide excellent bottom, bottom corner and sidewall coverage, with excellent resputtering from the recesses. He can provide excellent lower sidewall coverage. Other suitable processes gases can be used, such as other Noble gases, e.g. Ne, Kr, or Xe. Combinations of process gases can be used, such as He and Ar.

An RF power can be applied to the substrate to produce a DC bias during the step of depositing the deposition material. The RF power can be applied to the substrate to produce a DC bias of 100 to 500 V.

The step of depositing the deposition material can be performed at a chamber pressure in the range 2 to 150 mTorr. The step of depositing the deposition material can be performed at a chamber pressure in the range 30 to 100 mTorr.

The deposition material can be Ti, TiN, Ta, TaN, W, WN, Co, Ru or Cu. However, the deposition material is not limited to these examples.

The deposition material can be directly deposited from the target. In these examples, the deposition material corresponds to the material that the target is manufactured from. Alternatively, the deposition material can be deposited by reactive sputtering using a reactive gas. The reactive gas can be hydrogen, nitrogen or oxygen. The deposited material can be a hydride, a nitride or an oxide material.

The recesses can be vias. The recesses can be other recess features, such as trenches. The method of the invention can be incorporated into contact metallization applications.

The substantially uniform lateral magnetic field can be a magnetic field which has an average radial variation for the duration of the deposition of +/-25% across the surface of the substrate and also extending into a region beyond a periphery of the substrate. Optionally, this average radial variation for the duration of the deposition is +/-10%.

According to a second aspect of the invention there is provided a Physical Vapour Deposition (PVD) apparatus for depositing a deposition material into a plurality of recesses formed in a substrate comprising:
a chamber;
a magnetron device comprising a target disposed in the chamber from which a sputtering material can be sputtered; and
a substrate holder configured to hold a substrate of pre-defined dimensions comprising a substrate support disposed in the chamber;
in which:
   the substrate support comprises a substrate supporting upper surface and an arrangement of permanent magnets positioned beneath the substrate supporting upper surface so that, in use, permanent magnets are disposed underneath the substrate; and wherein the arrangement of permanent magnets is configured to provide, in use, a substantially uniform lateral magnetic field across the surface of the substrate which extends into a region beyond a periphery of the substrate to enhance resputtering of deposited material deposited into the recesses.

The arrangement of permanent magnets can be positioned beneath the substrate supporting upper surface so that permanent magnets are additionally disposed beyond the periphery of the substrate.

In use, the target and the substrate support can be separated by a gap of 2.5 to 7.5 cm.

The arrangement of permanent magnets can be moveable. The apparatus can further comprise a mechanism configured to subject the arrangement of permanent magnets to a motion which allows the substantially uniform lateral magnetic field to be provided in use. The mechanism can be a rotation mechanism for rotating the moveable arrangement of permanent magnets. The mechanism can be a reciprocating mechanism for reciprocating the moveable arrangement of permanent magnets.

The magnets in the arrangement of permanent magnets can be configured in a suitable two dimensional (2D) configuration. In use, this arrangement extends i) underneath the substrate and, optionally, ii) beyond the periphery of the substrate. The arrangement of permanent magnets can an array configured in a suitable pattern, such as a circularly disposed array of permanent magnets or a rectilinearly disposed array of permanent magnets.

It is understood that the substrate holder is configured and sized so as to process a substrate of a certain size and shape. The substrate holder can further comprise shielding and like furniture which is specific to a specific type of substrate. The substrate support can comprise a platen or chuck. The substrate support can be formed from a metallic material. The metallic material can be a metal or a metal alloy, such as aluminium or an aluminium alloy.

Typically, the apparatus comprises a controller which is configured to control the apparatus to perform a method according the first aspect of the invention.

The apparatus can comprise a RF power source connected to the substrate support. The RF power source allows an RF power to be applied to the substrate to produce a DC bias.

The apparatus can be provided in combination with the substrate positioned on the substrate supporting upper surface of the substrate support. The substrate can be a semiconductor substrate. The substrate can be a silicon substrate such as a silicon wafer.

Whilst the invention has been described above, it extends to any inventive combination of the features set out above, or in the following description, drawings or claims. For example, any features disclosed in relation to the first aspect of the invention may be combined with any features disclosed in relation to the second aspect of the invention and vice versa.

Embodiments of the invention will now be described, by way of example only, with reference to the accompanying drawings, in which:
Figure 1 is a semi-schematic cross sectional view of a via (a) without a constriction at the opening of the via and (b) with a constriction at the opening of the via;
Figure 2 is a semi-schematic view of an apparatus of the invention;
Figure 3 is a semi-schematic view of the substrate holder of Figure 2 including an arrangement of permanent magnets;
Figure 4 is a SEM (scanning electron microscope) image of a via with a titanium layer deposited using a prior art ionized PVD apparatus;
Figure 5 shows developed DC bias as a function of RF bias power and Target power;
Figure 6 is a SEM image of a via with a titanium layer deposited using an apparatus of the invention with Ar process gas;
Figure 7 shows SEM images of (a) the top and (b) the base of a via with a titanium layer deposited using an apparatus of the invention with He process gas; and
Figure 8 shows (a) a schematic representation of a via with a PVD deposited titanium layer showing 15 measurement points and (b) the thickness of the titanium layer, presented as % coverage values, at the 15 measurement points for PVD performed using the apparatus of the invention and a prior art ionized PVD apparatus and measured using a TEM (transmission electron microscope).

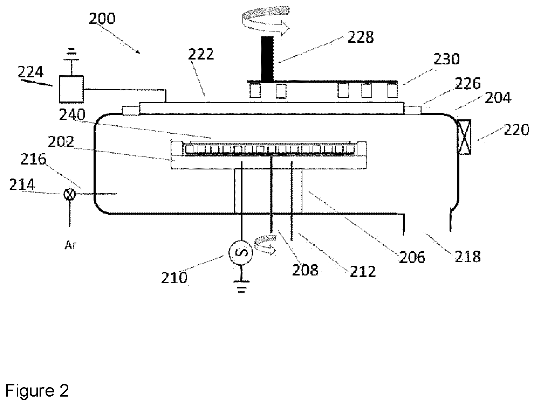

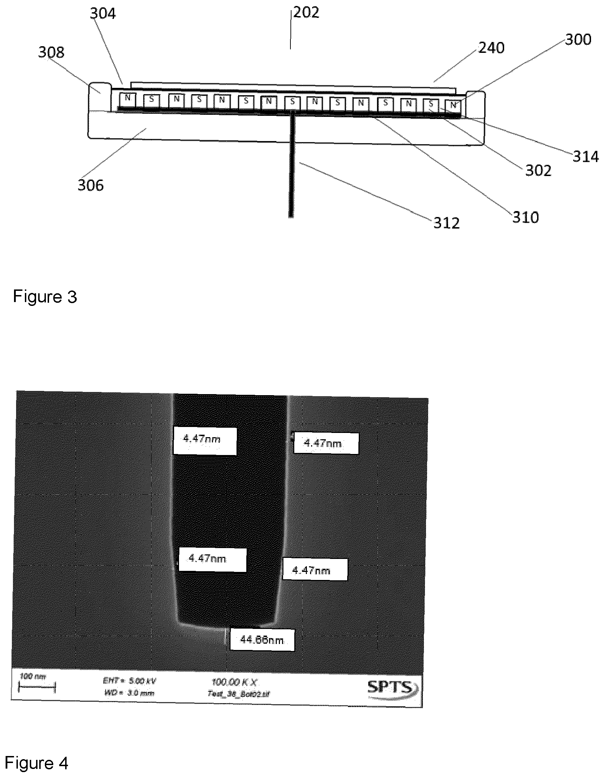

In Figure 2 shows a PVD apparatus 200 of the invention. A wafer 240 is positioned on a substrate supporting surface of a chuck 202 or platen within a vacuum chamber 204. The chuck 202 is part of a substrate support 206. Within the chuck 202 and below the wafer and the substrate supporting surface is an arrangement of permanent magnets, shown generally at 208. This arrangement is described in more detail below in relation to Figure 3. The apparatus further comprises an RF power source 210, which is connected to the substrate support 206 to provide an RF bias on the wafer 240. The RF power source 210 typically operates at 2-20MHz (usually 13.56MHz out of convention), although an RF electrical signal of any suitable frequency, such as 380-400kHz, could be used. Temperature control is achieved through resistive heating and fluid based cooling is achieved through a connection 212 which allows a cooling fluid to be flowed into and out of the chuck 202 in a manner well known to the skilled reader. One or more process gases enters the chamber through line isolation valve 214 and gas line 216. The process gas or gases can comprise one or more Noble gases such as Ar, He, Ne, Kr, Xe. He and/or Ar can be used with good results as described later. A reactive gas such as nitrogen, oxygen or hydrogen can be used as part of a reactive sputtering process. The line isolation valve 214 and line 216 are connected to a suitable gas manifold (not shown) which can deliver the desired process gas or gases. The apparatus is evacuated through an opening 218 same numeral as apparatus using a suitable vacuum pumping system (not shown). Wafer loading/unloading occurs through a slot valve 220. A target 222 is situated opposite the wafer 240 at the top of the chamber 204. The target 222 is driven by a negative DC power supply 224 and isolated from the grounded metal chamber through the use of dielectric isolation 226. Typically, the target is circular. A rotating magnet assembly 228 is positioned behind the target 222. The rotating magnet assembly 228 comprises permanent magnets 230 which help to trap electrons in the vicinity of the target 222 and provide full face erosion of the target 222. The target 222, rotating magnet assembly 228 and power supply 224 constitute a magnetron device which allows sputtering to take place. As explained in more detail below, the substrate support 206 provides capacitive coupling of RF and also magnetic enhancement of the resputtering process.

Figure 3 is a cross sectional view of the chuck 202 of Figure 2 with the wafer 240 in position. Figure 3 shows an arrangement of permanent magnets 300, 302 which can be used to provide enhanced deposition and resputtering. The wafer 240 to be processed is positioned on the substrate supporting surface 304 of the chuck 202. The chuck 202 comprises a lower part 306 and an upper part 308. The upper part 308 is an annular ring which carries the substrate supporting surface 304. The upper part 308 is attached to the lower part 306, and together the lower part 306, upper part 308 and substrate supporting surface 304 form a cavity within the chuck 202. Within the cavity, the array of the permanent magnets 300, 302 is positioned on a rotating plate 310 which is attached to a shaft 312. The rotating plate 310 rotates above the lower part 306 while the shaft 312 passes through an aperture in the lower part 306 to permit the shaft 312 to be rotated by a suitable drive mechanism (not shown). As shown in Figure 3, the magnets 300, 302 in the array are arranged along a linear cross sectional axis with alternate North 300 and South 302 polarities. Adjacent magnets of alternate polarity are separated by a spacing 314. It will be appreciated that Figure 3 is a cross sectional view which shows the arrangement along a single cross sectional axis. In practice, the arrangement of permanent magnets is a two dimensional (2D) array of suitable configuration which extends underneath the entire lower surface of the wafer substrate 240 and can also extend beyond the periphery of the substrate. The arrangement of permanent magnets provides strong local magnetic fields. Typical values of the magnetic field are 100-500 Gauss (0.01-0.05 Tesla) at the surface of the wafer 240 extending beyond the edge of the wafer.

The lower 306 and upper 308 parts of the chuck 202 and the main plate-like body of the substrate supporting surface 304 are typically fabricated using a metal such as aluminium or an alloy such as an aluminium alloy. The outermost portion of the substrate supporting surface 304 which is in contact with the wafer 240 can be coated with a CrO₂ coating to provide improved thermal performance. Surfaces can be frame sprayed or roughened by other means to retain sputtered material as is known to the skilled reader. Rotation of the array of permanent magnets enables a uniform lateral magnetic field to be produced at the wafer surface which in turn gives rise to excellent centre to edge uniformity of deposition across the wafer.

Experiments were performed using the apparatus shown in Figures 2 and 3 with a target to wafer separation of 4cm. Excellent base and sidewall coverage of high aspect ratio vias was achieved. The vias had an aspect ratio (depth of the feature/diameter of the feature) of greater than to 24:1 and a diameter of 0.5 micron. A 332mm diameter Ti target was used to deposit thin Ti barrier layers on 200mm diameter silicon wafers operating at low target powers (< 5W/cm²) without any additional plasma enhancement of the material sputtered from the target. Under these conditions, the system is operating without a high density of ionized Ti being emitted from the target (in other words, without a high ion fraction in the plasma). This is in contrast to prior art ionized PVD systems. The small target to wafer separation of 4cm would be expected to result in a significant amount of sputtered material reaching the wafer with non-normal incidence. It is anticipated that target to wafer separations of 2.5-7.5cm would operate in a similar fashion. Beyond this range of target to wafer separations it is possible that uniformity and deposition rate would be a concern unless ionized PVD techniques were employed.

Surprisingly, it was found that it was possible to avoid closure of the via openings during deposition and achieve excellent base and sidewall coverage of these very high aspect ratio features, due to an enhanced etch performance. One set of experiments were performed with the following operating conditions: 82mTorr Ar pressure; 0.4kW Target power (0.46W/cm²); 120V DC Bias; rotation of the array of permanent magnet at *ca.* 5-10 rpm. The resulting step coverage results are shown in Table 1, which indicates that excellent centre to edge uniformity was achieved in the high aspect ratio features. It is notable that even at the edge of the wafer, minimal shadowing (caused by the via profile) was observed. It is believed that enhanced resputtering of material on the wafer surface and within the deep features avoided closure of the vias, and enabled good base coverage and excellent sidewall coverage.

**Table 1. Comparison of step coverage measured by SEM at the wafer centre and edge.**

| | Wafer Centre | Wafer Edge |
|---|---|---|
| Field | 100% | 100% |
| Side wall | 3.8% | 6.6% |
| Corner | 10.8% | 11.9% |
| Bottom | 15.7% | 13.1% |

A performance comparison was made between the apparatus of the invention shown in Figures 2 and 3, and the prior art i-PVD module manufactured by the applicant (an advanced HiFill^{™} PVD module on a Sigma fxP ^{™} PVD apparatus, which is commercially available from SPTS Technologies Limited, located in Newport, South Wales, UK).

In the prior art advanced HiFill^{™} PVD chamber, a high platen DC bias and solenoid coils surrounding the chamber are used in conjunction with a long throw design to improve step coverage. Ti deposition into high aspect ratio vias (25:1) was performed using 1mT Ar process gas at 40kW target power (46W/cm²), with 450W RF bias (resulting in 110V DC bias) combined with a target to substrate distance of ca. 350mm. As shown in Figure 4, good base coverage ([thickness of coverage at base of feature/ thickness in the field]%) of up to 19% that of the field (232nm) was achieved. However, only a very small amount of this material is resputtered onto the sidewalls at the bottom of the via, giving only 2% coverage.

Using the apparatus of the invention, it is possible to achieve a much higher degree of resputtering. With a target power of 0.25kW (ca. 0.29W/cm²), an RF power of 100W and a chamber pressure of 3.5mTorr, a bias of 110V is achieved. However, these conditions resulted in negligible resputtering at the bottom of the via. Base coverage was ca. 5%, which is worse than with the prior art system when a similar pressure was used and a similar DC bias was developed, albeit with a much higher target power This suggests that insufficient deposition is reaching the wafer.

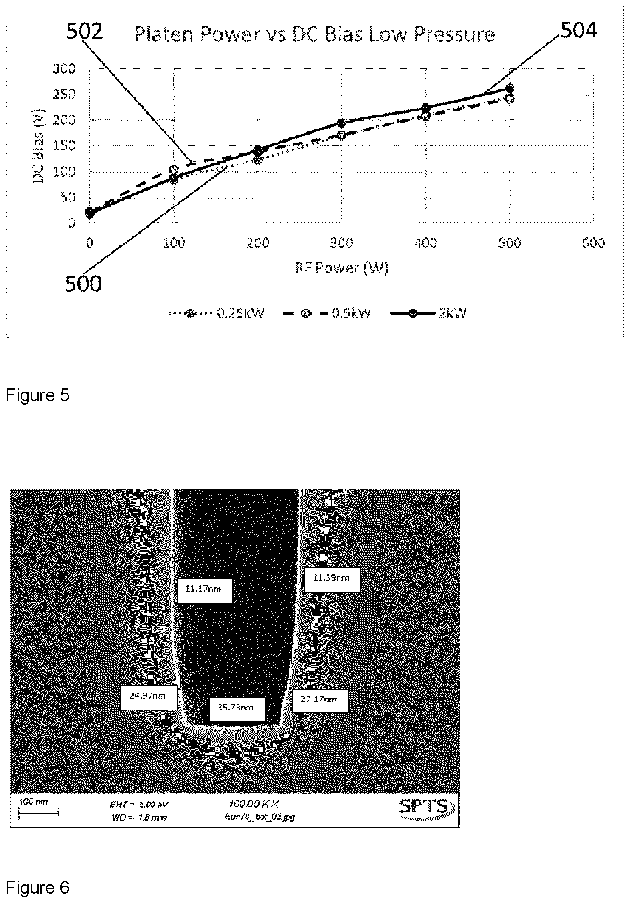

It is to be noted that a larger degree of resputtering is useful only if the base coverage can be increased. This is because material must first be deposited onto the base of the via for it to be resputtered onto the sidewalls. To achieve a more conformal base coverage required fine tuning of the bias and target power. Figure 5 shows DC bias as a function of RF bias power and target power using the apparatus of the invention. The developed DC bias in V is shown as a function of RF power in W for target powers of 0.25kW 500, 0.5kW 502 and 2kW 504. As RF power is increased, very high DC bias values are achieved. However, it can be seen that DC bias does not increase with increasing target power for a given value of the RF power. In view of these results, we postulate that for a given RF power to the chuck, the rate of resputtering is relatively constant. This suggests that the values of the target power and RF power are important in achieving sufficient resputtering for a given target film thickness.

Significant improvement was made to base coverage by substantially increasing Ar pressure to 100mTorr, to increase scattering, while increasing target power density to 0.4W/cm2 and substrate DC bias to 123V as can be seen in Figure 6. This gave a bottom coverage of 17% and also a bottom corner coverage of 12%, which is far superior to the prior art system.

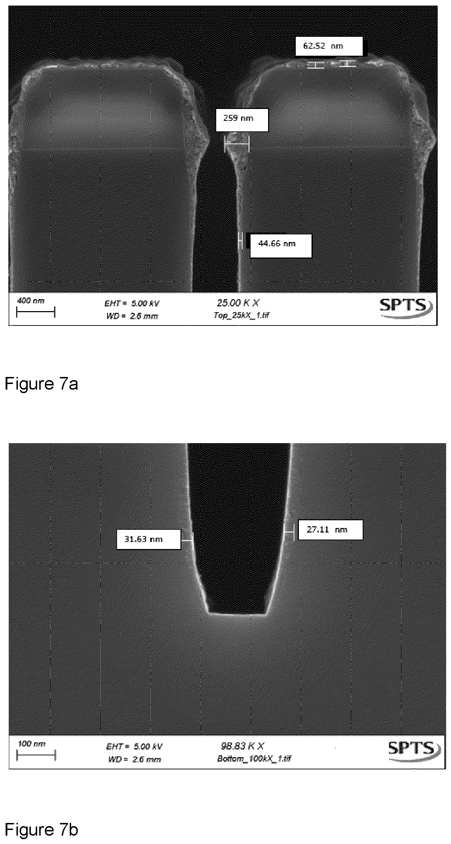

The type of process gas used is another process parameter that can be used to control resputtering. As previously stated, when Ar is used as the process gas, a higher RF power results in enhanced resputtering due to the DC bias on the wafer. The RF power is seen to direct ionized material to the bottom of the via. However, it can be advantageous to selectively direct large quantities of a deposition material such as Ti to the bottom of a via without a large degree of resputtering. This is a way in which coverage of the via bottom may be increased substantially. The use of He gas was investigated using a very high RF power to direct Ti into the via. Due to the small mass of the He ions, the amount of resputtering would be relatively small. Thus, high RF powers could be used to direct Ti into the via without the via opening becoming closed due to resputtering. We found that this scheme works for high DC bias values of greater than 200V, where bottom sidewall coverage of ca. 50% that of the field was observed. Figure 7 shows the excellent result achieved operating at 20mTorr of He with 0.25kW target power and 400W RF bias producing a DC bias of 227V. This DC bias was high enough to sputter material from the bottom of the via (Figure 7(b)) while avoiding closure of the via (Figure 7(a)). Equivalent tests using Ar as the process gas resulted in the closure of the via. This occurred because material was resputtered into the via opening, resulting in closure of the via, before significant quantities of material could be deposited onto the bottom of the via. These results were taken as an indication that the use of the lighter process gas results in a lesser amount of resputtering but a higher degree of directionality.

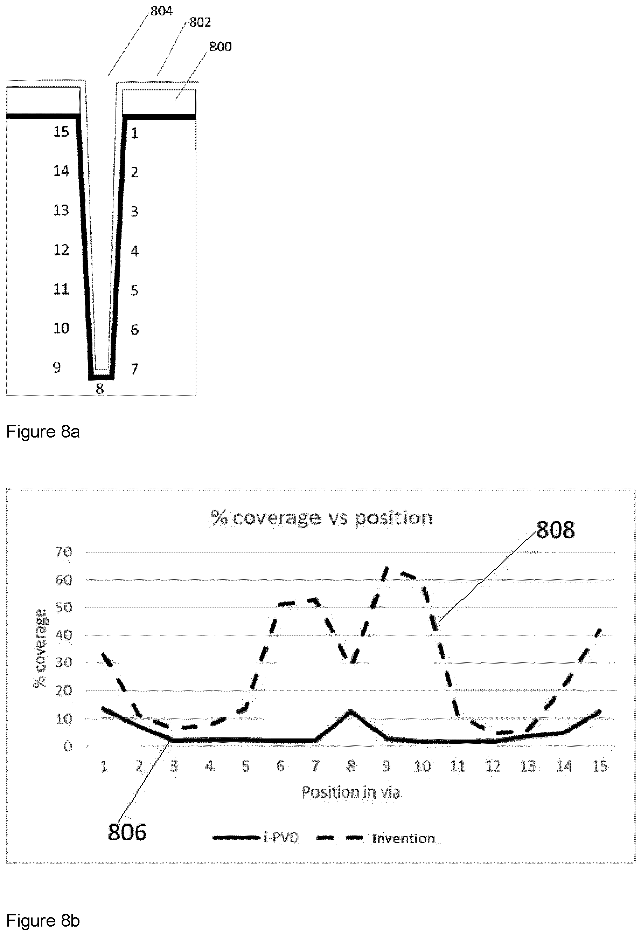

Fig 8(a) is a sketch of a Ti layer 802 deposited into a high aspect ratio feature 804 (25:1 aspect ratio, 0.5 micron diameter opening) using a hard mask 800. Figure 8(a) also shows 15 TEM measurement points 1-15 for measuring the thickness of the Ti layer. Figure 8(b) shows a plot of a series of high resolution TEM measurements of the Ti thickness taken at the 15 points shown in Figure 8(a) following deposition of Ti using both the prior art i-PVD system 806 and the present invention 808 under conditions which were optimized for the feature. It can be seen that, at all points, the present invention provides improved coverage within the via when compared to the prior art system.

Without wishing to be bound by any particular theory or conjecture, we propose that the relatively strong (100-500 Gauss) uniform magnetic field substantially parallel with the wafer surface reduces electron loss from the RF driven platen assembly. In turn, this increases ionization for a fixed RF power. This produces a more dense plasma which can more efficiently resputter material that is present on the wafer surface and within the via. The magnetic field providing this enhancement in resputtering is not attenuated within the vias. This is in contrast to the immersed coil of prior art systems such as that described in US2018/0327893 A1, which lies above the wafer and provides an enhancement of the plasma in the vicinity of the wafer as long as the plasma is above the wafer. However, the plasma will diminish as it reaches within the via.

A relatively small target to wafer separation provides a high flux of sputtered material reaching the wafer even at relatively low target power densities (<5W/cm²). Through judicious choice of process parameters such as pressure, target power, DC bias and process gas, excellent results can be achieved. A mixture of Ar and He (or other process gas mixtures) could be used to provide a desired process performance. The methodologies and information provided herein can be used directly or readily adapted by the skilled person through routine experimentation to provide excellent results when depositing materials into recessed features by PVD across a wide range of implementations and applications. For example, by introducing a reactive gas such as N₂ or O₂, a nitride or oxide deposition could be achieved using the present invention.

## Claims

1. A method of depositing a deposition material into a plurality of recesses formed in a substrate by Physical Vapour Deposition (PVD) comprising the steps of:
positioning the substrate on a substrate supporting upper surface of a substrate support, wherein an arrangement of permanent magnets is positioned beneath the substrate supporting upper surface so that permanent magnets are disposed underneath the substrate; and
depositing the deposition material into the recesses formed in the substrate by sputtering a sputtering material from a target of a magnetron device;
in which, during the step of depositing the deposition material, the arrangement of permanent magnets provides a substantially uniform lateral magnetic field across the surface of the substrate which extends into a region beyond a periphery of the substrate to enhance resputtering of deposited material deposited into the recesses.

2. A method according to claim 1 in which the arrangement of permanent magnets is positioned beneath the substrate supporting upper surface so that permanent magnets are additionally disposed beyond the periphery of the substrate.

3. A method according to claim 1 or claim 2 in which the target and the substrate are separated by a gap of 2.5 to 7.5 cm, optionally by a gap of 2.5 to 4 cm.

4. A method according to any one of claims 1 to 3 in which a DC power is applied to the target to sputter the material with an applied power density of 0.1 to 5 Wcm², optionally 0.25 to 1 Wcm⁻².

5. A method according to any previous claim in which the arrangement of permanent magnets is moveable and, during the step of depositing the deposition material, the arrangement of permanent magnets is subjected to a motion which allows the substantially uniform lateral magnetic field to be provided, wherein optionally the motion that the moveable arrangement of permanent magnets is subjected to is a reciprocating motion.

6. A method according to claim 5 in which the motion that the moveable arrangement of permanent magnets is subjected to is rotation, in which optionally the moveable arrangement of permanent magnets is rotated at 2.5 to 15 rpm, preferably 5 to 10 rpm.

7. A method according to any previous claim in which the substantially uniform lateral magnetic field which is provided across the surface of the substrate and extends into a region beyond the periphery of the substrate has a magnetic field strength in the range 100-500 Gauss (0.01-0.05 Tesla).

8. A method according to any previous claim in which Ar and/or He is used as a process gas during the step of depositing the deposition material.

9. A method according to any previous claim in which an RF power is applied to the substrate to produce a DC bias of 100 to 500 V during the step of depositing the deposition material.

10. A method according to any previous claim in which the step of depositing the deposition material is performed at a chamber pressure in the range 2 to 150 mTorr, optionally 30 to 100 mTorr.

11. A method according to any previous claim in which the deposition material is Ti, TiN, Ta, TaN, W, WN, Co, Ru or Cu and/or the deposition material is deposited by reactive sputtering using a reactive gas, optionally hydrogen, nitrogen or oxygen.

12. A method according to any previous claim in which the recesses are vias.

13. A Physical Vapour Deposition (PVD) apparatus for depositing a deposition material into a plurality of recesses formed in a substrate comprising:
a chamber;
a magnetron device comprising a target disposed in the chamber from which a sputtering material can be sputtered; and
a substrate holder configured to hold a substrate of pre-defined dimensions comprising a substrate support disposed in the chamber;
in which:
the substrate support comprises a substrate supporting upper surface and an arrangement of permanent magnets positioned beneath the substrate supporting upper surface so that, in use, permanent magnets are disposed underneath the substrate; and wherein the arrangement of permanent magnets is configured to provide, in use, a substantially uniform lateral magnetic field across the surface of the substrate which extends into a region beyond a periphery of the substrate to enhance resputtering of deposited material deposited into the recesses.

14. A PVD apparatus according to claim 13 in which:
the arrangement of permanent magnets is positioned beneath the substrate supporting upper surface so that permanent magnets are additionally disposed beyond the periphery of the substrate; and/or
in use, the target and the substrate support are separated by a gap of 2.5 to 7.5 cm; and/or
the arrangement of permanent magnets is moveable, and the apparatus further comprises a mechanism configured to subject the arrangement of permanent magnets to a motion which allows the substantially uniform lateral magnetic field to be provided in use, in which optionally the mechanism is a rotation mechanism for rotating the moveable arrangement of permanent magnets; and/or
the PVD apparatus comprises a controller which is configured to control the apparatus to perform a method according to any one of claims 1 to 12.

15. A PVD apparatus according to claim 13 or claim 14 in combination with the substrate positioned on the substrate supporting upper surface of the substrate support.
